# EUROPÄISCHE PATENTSCHRIFT

(11) **EP 0 978 224 B1**
(45) Veröffentlichungstag und Bekanntmachung des Hinweises auf die Patenterteilung: **02.01.2002**
(21) Anmeldenummer: 98932000.7
(22) Anmeldetag: 23.04.1998
(51) Int. Cl.: H05K 3/24, C25D 5/00, C25D 17/00

(54) **VORRICHTUNG ZUM ELEKTROLYTISCHEN BEHANDELN VON PLATTENFÖRMIGEM BEHANDLUNGSGUT UND VERFAHREN ZUM ELEKTRISCHEN ABSCHIRMEN VON RANDBEREICHEN DES BEHANDLUNGSGUTES BEI DER ELECTROLYTISCHEN BEHANDLUNG**
DEVICE FOR ELECTROLYTIC TREATMENT OF PLATE-SHAPED ARTICLES AND METHOD FOR ELECTRONIC SHIELDING OF EDGE AREAS OF ARTICLES DURING ELECTROLYTIC TREATMENT
DISPOSITIF POUR LE TRAITEMENT ELECTROLYTIQUE D'ARTICLES SOUS FORME DE PLAQUETTES, ET PROCEDE DE PROTECTION ELECTRIQUE DE ZONES MARGINALES DE TELS ARTICLES LORS DU TRAITEMENT ELECTROLYTIQUE

(30) Priorität: 25.04.1997 DE 19717510
(43) Veröffentlichungstag der Anmeldung: 09.02.2000
(73) Patentinhaber: ATOTECH Deutschland GmbH, 10553 Berlin (DE)
(72) Erfinder: KOPP, Lorenz, D-90518 Altendorf (DE); PLÖSE, Wolfgang, D-16816 Neuruppin (DE); WÄCHTER, Ralf-Peter, D-90518 Altendorf (DE)
(74) Vertreter: Effert, Bressel und Kollegen
(86) Internationale Anmeldenummer: DE9801152
(87) Internationale Veröffentlichungsnummer: WO9849375

(56) Entgegenhaltungen:
- US-A- 3 862 891
- US-A- 4 879 007
- "THIEVING BLOCK" IBM TECHNICAL DISCLOSURE BULLETIN, Bd. 33, Nr. 3B, 1. August 1990, Seite 401/402 XP000124404

## Beschreibung

Die Erfindung betrifft eine Vorrichtung zum elektrolytischen Behandeln von plattenförmigem Behandlungsgut sowie ein Verfahren zum elektrischen Abschirmen von Randbereichen des Behandlungsgutes. Vorzugsweise werden die Vorrichtung und das Verfahren bei der Galvanisierung oder beim Ätzen von Leiterplatten und Leiterfolien in Durchlaufanlagen mit beim Durchlauf horizontaler oder vertikaler Ausrichtung des Behandlungsgutes angewendet.

In Durchlaufgalvanisieranlagen wird im allgemeinen unterschiedlich breites Behandlungsgut produziert. Die Anoden in den Anlagen müssen so dimensioniert sein, daß auch die breitesten Platten und Folien problemlos behandelt werden können. Werden unter diesen Umständen in der Anlage quer zur Transportrichtung des Behandlungsgutes schmalere Platten oder Folien galvanisiert, so werden in deren Randbereichen erheblich dickere Metallschichten als in der Mitte erzeugt, weil sich die elektrischen Feldlinien in diesen Randbereichen konzentrieren. Üblicherweise wird eine bestimmte Toleranz für die Metallschichtdicke vorgegeben, so daß der praktisch nutzbare Bereich auf den metallisierten Platten und Folien gegenüber deren Gesamtbreite verringert wird. Bei der Herstellung von Leiterplatten und Leiterfolien ist nur eine geringe Toleranz für die Metallschichtdicken zulässig, die sich aus Anforderungen bei der nachfolgenden Bearbeitung der Platten und Folien ergeben. Des weiteren handelt es sich bei Leiterplatten in der Regel um teure Werkstoffe. Deshalb wird eine maximale Ausnutzung der galvanisierten Rohleiterplatten, die auch als Nutzen bezeichnet werden, angestrebt. Daher soll eine gleichmäßige Schichtdicke bis in den Randbereich der Leiterplatten bzw. -folien erzielt werden. Eine bekannte Maßnahme zur Beeinflussung der Schichtdicke im Randbereich des Galvanisiergutes besteht im elektrischen Abblenden dieser Randbereiche mit elektrisch nichtleitenden Blenden.

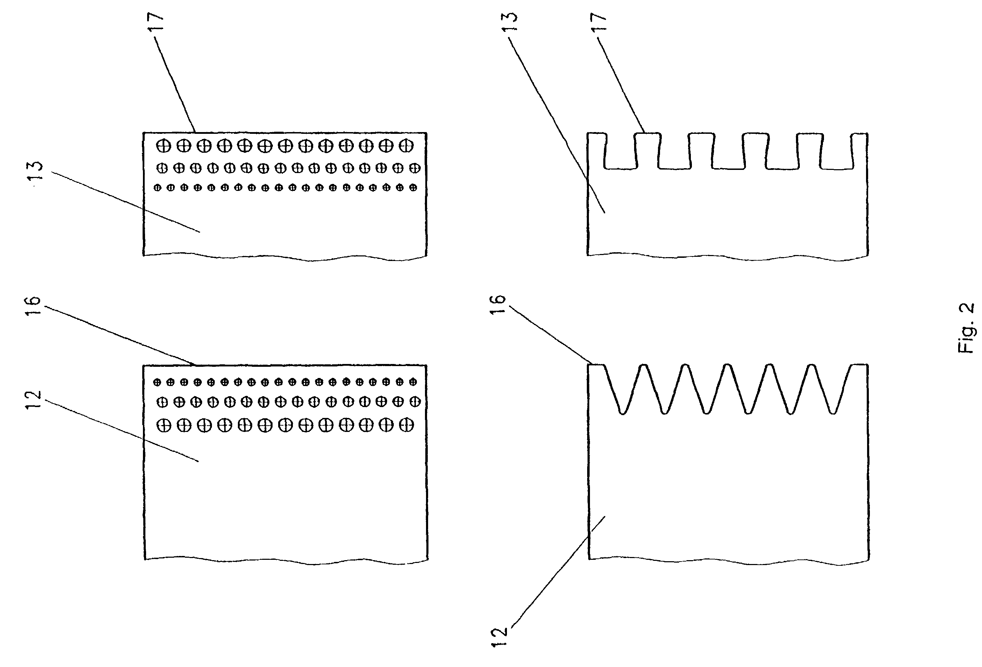

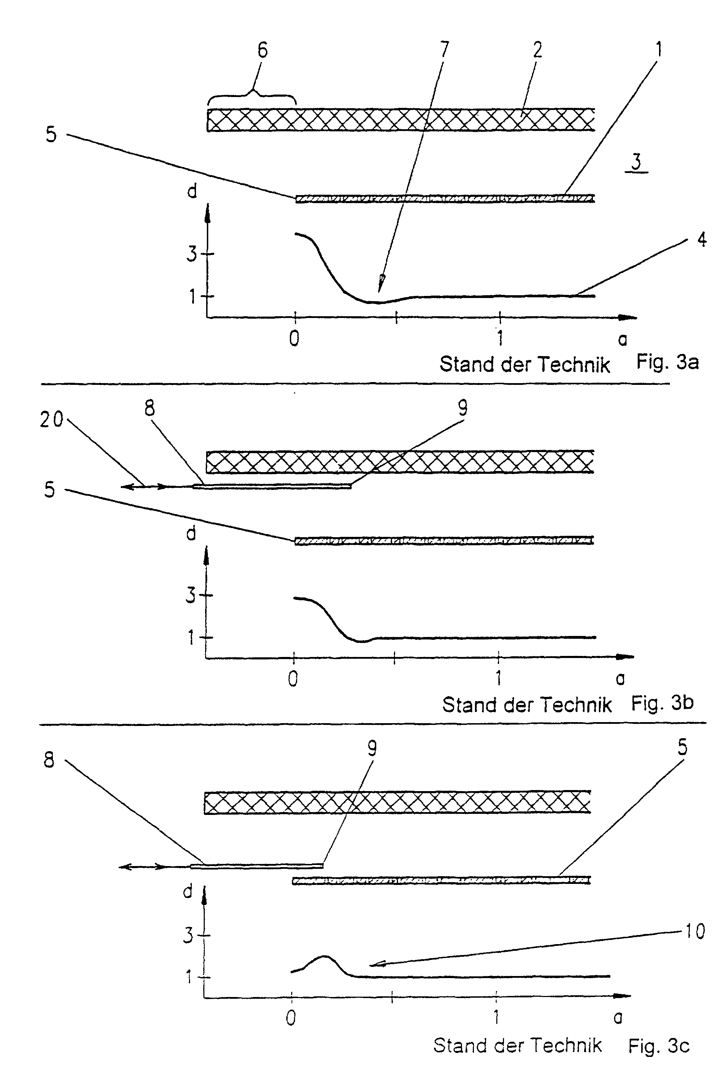

In DE-P 39 37 926 C2 sind Vorrichtungen zum Abblenden von Feldlinien in einer Galvanikanlage zur Behandlung insbesondere von Leiterplatten beschrieben. In den dort enthaltenen Figuren 2 und 3 sind Blenden dargestellt, die aus mehreren Teilblenden bestehen, die in sich individuell einstellbar sind. Durch Drehung der Teilblenden um eine Achse kann die Blendwirkung jeder einzelnen Teilblende vergrößert oder verkleinert werden. Bei genügend schmalen Einzelblenden und damit einer ausreichend großen Anzahl dieser Blenden kann die Randabdeckung optimal eingestellt werden.

Als Nachteil ist jedoch in Kauf zu nehmen, daß eine Restabblendung über dem eigentlich nicht abzuschirmenden Bereich der Leiterplatten verbleibt. Ferner ist der konstruktive Realisierungsaufwand für diese Vorrichtung beträchtlich. Deshalb wird in der Praxis eine ebene Blende zwischen den Anoden und dem Randbereich des Behandlungsgutes bevorzugt, so wie in Figur 4 in der vorgenannten Druckschrift dargestellt ist. Eine optimale profilartige Abblendung ist bei dieser Anordnung der Blenden jedoch nicht möglich, so daß die geforderten Schichtdickentoleranzen in einem größeren Randbereich auf dem Nutzen nicht erreicht werden können. Außerdem ist auch bei dieser Anordnung der große technische Realisierungsaufwand nachteilig.

Der Galvanisierbetrieb erfordert robuste Konstruktionen. Deshalb hat sich in der Praxis eine flache verschiebbare Blende durchgesetzt, ähnlich wie sie aus JP-A-62/151 593 bekannt ist. Die dort verwendeten Blenden werden von einem linear wirkenden Antrieb zwischen die Anoden und den Randbereich des Behandlungsgutes geschoben.

Diese und ähnlich flach ausgebildete Blenden reduzieren die Feldlinienkonzentration im Randbereich des Behandlungsgutes in Abhängigkeit von der Überdeckung des Behandlungsgutes durch die Blende und vom Abstand der Blende von der Anode bzw. von der Oberfläche des Behandlungsgutes. Von Bedeutung ist auch der Abstand der Anoden vom Behandlungsgut sowie die anodische und die kathodische Stromdichte beim elektrolytischen Behandeln. Die Blendenstellung beim elektrolytischen Behandeln stellt einen Kompromiß aus diesen Parametern dar, so daß die optimale Abblendung in aufwendigen Versuchen ermittelt werden muß. Ziel ist es, eine große nutzbare Fläche innerhalb des zulässigen Toleranzbereiches ohne Kantenanbrennungen bei hohen Stromdichten zu erreichen. Bei Feinleiterplatten und mittleren Stromdichten ist der nicht nutzbare Rand in der Praxis etwa 30 mm breit. Bei Stromdichten bis zu 15 A/dm² ist der nicht nutzbare Rand mit dieser Blende bereits etwa 50 mm breit.

In US-A-3,862,891 ist eine Galvanisiereinrichtung beschrieben, die ein Galvanisiergestell und Anoden sowie eine elektrisch nichtleitende Abschirmblende zur Vergleichmäßigung der Feldlinienkonzentration an dem an einem Warenträger befestigten Galvanisiergut aufweist. Die Abschirmblende besteht aus mehreren Blendenteilen, die mit der Einrichtung fest verbunden sind, indem sie an den Seitenwänden fixiert und in geeigneten Führungen verschraubt sind. Die Blendenteile sind parallel zueinander und parallel zum Galvanisiergut und den Anoden ausgerichtet. Die Blendenteile ragen in den Raum zwischen dem Galvanisiergut und den Anoden teilweise hinein, wobei die den Anoden näher gelegenen Blendenteile weiter hineinragen als die dem Galvanisiergut näher gelegenen Blendenteile. Es wird angegeben, daß mit dieser Einrichtung eine gleichmäßige Galvanisierschichtdicke in der Ebene des Galvanisiergestells erreicht werden kann.

Mit dieser Einrichtung ist es nicht möglich, Behandlungsgut mit unterschiedlichen Außenabmessungen elektrolytisch optimal zu behandeln, wobei eine vorgegebene Toleranz der Metallschichtdicke nur auf einem möglichst schmalen Randbereich des Behandlungsgutes nicht erreicht wird, während die übrige Oberfläche des Behandlungsgutes an allen Stellen den Anforderungen an die Gleichmäßigkeit der Metallschichtdicke genügt. Insbesondere ist ein kontinuierlicher Betrieb gewünscht, um eine geringe Rüstzeit zu ermöglichen.

Der vorliegenden Erfindung liegt von daher das Problem zugrunde, die Nachteile des Standes der Technik zu vermeiden und insbesondere eine Vorrichtung zum elektrolytischen Behandeln von plattenförmigem Behandlungsgut zu finden, mit der die Platten bzw. Folien kontinuierlich elektrolytisch behandelt werden können und die Vorrichtung gleichzeitig jederzeit schnell automatisch oder gegebenenfalls manuell an wechselnde Formate/Breiten der zu behandelnden Platten oder Folien angepaßt werden kann, um eine Vergleichmäßigung der Metallschichtdicke auf den Platten- bzw. Folienoberflächen zu erreichen. Beim kontinuierlichen Betrieb soll der Randbereich der Platten bzw. Folien, in dem vorgegebene Schichtdickentoleranzen nicht eingehalten werden können, möglichst gering sein. Zusätzlich wird aber auch gefordert, einen möglichst hohen Elektrolysestrom anzuwenden, um die Platten bzw. Folien mit kurzer Behandlungszeit elektrolysieren zu können, damit ein hoher Durchsatz des Behandlungsgutes pro Zeiteinheit mit der Einrichtung möglich wird. Auch bei großem Elektrolysestrom soll die Dicke der Metallschicht auf dem Behandlungsgut bis in den Randbereich immer möglichst gleichmäßig sein.

Gelöst wird dieses Problem durch die elektrolytische Behandlungsvorrichtung gemäß Anspruch 1 und das elektrische Abschirmverfahren gemäß Anspruch 10.

Die erfindungsgemäße Vorrichtung stellt im wesentlichen eine Durchlaufanlage dar, durch die das Behandlungsgut in einer Transportebene in im wesentlichen horizontaler Transportrichtung hindurchführbar ist. In dieser Durchlaufanlage sind der Transportebene im wesentlichen parallel gegenüberliegende Gegenelektroden angeordnet sowie zwischen der Transportebene und den Gegenelektroden angeordnete Blenden zum Abschirmen erhöhter Stromdichtefelder im Randbereich des Behandlungsgutes. Die Blenden sind jeweils in Form von mindestens zwei im wesentlichen parallel zueinander angeordneten Flachteilen ausgebildet, wobei der eine Teil der Blenden der Transportebene und der andere Teil den Gegenelektroden gegenüberliegend angeordnet ist. Die Blenden sind in einer Richtung verschiebbar gelagert, die im wesentlichen parallel zur Transportebene und im wesentlichen senkrecht zur Transportrichtung verläuft.

Im übrigen weist die Durchlaufanlage die für die elektrolytische Behandlung weiteren erforderlichen Merkmale auf, beispielsweise Behälter zur Aufnahme der Behandlungsflüssigkeit, gegebenenfalls Düsen, Pumpen und Rohrleitungen zur Überführung von Flüssigkeit zu den einzelnen Aggregaten, Antriebsaggregate für den Transport des Behandlungsgutes durch die Anlage und Führungselemente zur Halterung in der Anlage sowie Stromquellen, Kontaktierelemente für die Elektroden und das Behandlungsgut und Stromzuführungen.

Das erfindungsgemäße Verfahren dient zum elektrischen Abschirmen von Randbereichen von plattenförmigem Behandlungsgut bei dessen elektrolytischer Behandlung in der Durchlaufanlage.

Die Vorrichtung und das Verfahren sind zur elektrolytischen Behandlung insbesondere von Leiterplatten und Leiterfolien geeignet. Das Behandlungsgut kann entweder elektrolytisch metallisiert oder geätzt werden. Im einen Fall wird das Behandlungsgut als Kathode, und die Gegenelektroden werden als Anoden geschaltet, während das Behandlungsgut und die Gegenelektroden im anderen Fall mit vertauschter Polung geschaltet werden.

Bevorzugte Ausführungsformen der Erfindung sind in den Unteransprüchen angegeben.

Der der Transportebene unmittelbar gegenüberliegende Teil der Blenden ist gegenüber dem anderen Teil der Blenden um einen Abstand b zur Kante des Behandlungsgutes hin zurückspringend angeordnet. Dadurch wird eine sehr wirksame Abschirmung der Randbereiche des Behandlungsgutes gegen eine Konzentrierung der Feldlinien ermöglicht. Ohne eine derartige Staffelung der Blendenteile wäre eine optimale Vergleichmäßigung der Metallschichtdicken nicht erreichbar.

Um die Blendeneinrichtung an wechselnde Formate der jeweils zu behandelnden Platten oder Folien besonders gut anzupassen, können die Flachteile der Blenden unabhängig voneinander verschiebbar gelagert sein. Durch vorher zu ermittelnde Positionen der Blendenteile relativ zur Lage der Anoden und des durchlaufenden Behandlungsgutes werden die jeweiligen Positionen der Blendenteile ermittelt und beim Durchlauf derartiger Formate eingestellt.

Insbesondere kann der vorstehend erwähnte Abstand b durch geeignete Konstruktionselemente einstellbar sein. Vorzugsweise sind auch die Abstände der Flachteile zur Gegenelektrode und zur Transportebene unabhängig voneinander einstellbar.

Zur automatischen Einstellung des Abstandes b sowie der Abstände der Flachteile zur Gegenelektrode und zur Transportebene kann beispielsweise ein gesteuerter Motorantrieb vorgesehen sein, mit dem die Blenden verschoben werden können.

In einer bevorzugten Ausführungsform weisen die Flachteile Randbereiche auf, die mit dem Behandlungsgut und den Gegenelektroden zur Überdeckung bringbar sind, wobei diese Randbereiche Durchbrechungen und/oder an den Kanten Aussparungen aufweisen.

Um auch schmalere Nutzen wirksam behandeln zu können, sind die Flachteile senkrecht zur Transportrichtung gesehen so breit auszuführen, daß auch schmales Behandlungsgut im Randbereich sicher abgeblendet werden kann.

Im allgemeinen werden die Gegenelektroden, die vorzugsweise an beiden Seiten der Transportebene angeordnet sind, bei längeren Durchlaufanlagen in Transportrichtung gesehen in mehrere Teilsegmente unterteilt, um eine separate Abschaltung der Elektroden zu gewährleisten. Dies ist erforderlich, um einen Stromfluß über Gegenelektroden, denen sich kein Behandlungsgut gegenüber befindet, zu vermeiden. Falls der Stromfluß an diesen Teilsegmenten nicht abgeschaltet werden könnte, würde die Stromdichte in den Randbereichen an den Stirnkanten der Platten und Folien erhöht sein, so daß dort eine Metallschicht mit einer außerhalb der geforderten Toleranz liegenden Dicke abgeschieden werden würde. Vorzugsweise weisen die erfindungsgemäßen Blenden bei einer derartigen Segmentierung der Gegenelektroden in Transportrichtung gesehen eine Länge auf, die der Länge der Teilsegmente der Gegenelektroden entspricht.

Die Erfindung wird nachfolgend an Hand der Figuren 1 bis 3 näher beschrieben. Es zeigen:
- Figur 1a:: Doppelblende im Querschnitt und damit erhaltener Schichtdickenverlauf;
- Figur 1b:: Doppelblende in Draufsicht;
- Figur 2:: Randbereiche von verschiedenen Flachteilen von Blenden in Draufsicht;
- Figur 3a:: schematische Darstellung der Galvanisieranordnung im Querschnitt ohne Abschirmblende nach dem Stand der Technik und damit erhaltener Schichtdickenverlauf;
- Figur 3b und 3c:: schematische Darstellungen von Blendenanordnungen im Querschnitt nach dem Stand der Technik und damit erhaltene Schichtdickenverläufe.

Der üblicherweise erhaltene Schichtdickenverlauf auf einem plattenförmigen Behandlungsgut bei einer Galvanisieranordnung ohne Abschirmblenden nach dem Stand der Technik ist in Figur 3a dargestellt. Entsprechende Verläufe bei Verwendung bekannter Blendenanordnungen mit nur einem Blendenteil sind in den Figuren 3b und 3c wiedergegeben.

Figur 3a zeigt die Schichtdicke d einer nicht abgeblendeten Kante, beispielsweise einer Leiterplatte, nach der Galvanisierung. Im mittleren Bereich des Nutzens wird eine relative Schichtdicke von d = 1, in der Praxis mit einer Schichtdicke von beispielsweise 0,03 mm, erreicht. Diese Schichtdicke stellt zugleich die Soll-Schichtdicke dar. Die Position des Behandlungsgutes 1, beispielsweise einer Leiterplatte, zur Anode 2 ist im Querschnitt quer zur Transportrichtung dargestellt. Im außerhalb der Figur liegenden Bereich 3 befindet sich die nicht dargestellte elektrische Kontaktierung der Leiterplatte. Auch Transport- und Führungselemente für die Leiterplatten in der Durchlaufgalvanisieranlage sind in der Figur nicht wiedergegeben.

Weil sich die Schichtdickenverläufe an der Unterseite der Leiterplatte spiegelbildlich zu den Verläufen an der Oberseite verhalten, ist nur eine Anode an einer Seite dargestellt. Der Anoden/Kathodenabstand, d.h. die Entfernung der Anodenoberfläche zur Oberfläche des Behandlungsgutes, beträgt bei Durchlaufgalvanisieranlagen in der Praxis etwa 60 mm bis etwa 120 mm. Der hier schematisch skizzierte Schichtdickenverlauf 4 erreicht erst bei einem relativen Abstand a = 1 von der seitlichen Leiterplattenkante 5 die relative Soll-Schichtdicke d = 1. An der seitlichen Leiterplattenkante konzentrieren sich die elektrischen Feldlinien nicht nur zu Lasten der von der über die Leiterplatten hinaus überstehenden Anodenoberfläche ausgehenden Feldliniendichte sondern auch zu Lasten der sich in einem Bereich auf der Leiterplatte einstellenden lokalen Stromdichte. Deshalb bildet sich dort ein störender "Schichtdickengraben" 7 mit einer relativen Dicke von weniger als d = 1 aus. Die größte Schichtdicke bildet sich im vorliegenden Fall unmittelbar an der seitlichen Leiterplattenkante. Um sogenannte Anbrennungen (pulverförmige Metallschicht, die sich in der Regel bei zu hoher kathodischer Stromdichte bildet) zu vermeiden, muß diese Spitzenstromdichte unterhalb einer Grenzstromdichte liegen, bei der derartige Anbrennungen entstehen. Daher muß eine entsprechend niedrigere mittlere Stromdichte bei der Galvanisierung eingestellt werden.

In Figur 3b ist eine Galvanisieranordnung schematisch wiedergegeben, die eine flache, in der Nähe der Anode 2 verschiebbar angeordnete Blende 8 aufweist. Durch Nutzung dieser Blende wird am grundsätzlichen Verlauf der Schichtdicke jedoch nichts geändert. Auch in diesem Fall bildet sich ein "Schichtdickengraben" aus, wenn auch schwächer als ohne Anwendung der Blende. Durch die schwächere Ausbildung dieses Grabens wird der nutzbare Bereich des Leiterplattennutzens allerdings größer.

Im Fall der Anordnung gemäß Figur 3c ist der nutzbare Bereich etwa genauso groß wie im Fall der Anordnung nach Figur 3b. Hier ist die Blende 8 nahe an der Oberfläche des Behandlungsgutes 1 angeordnet. Mit geringer werdendem Abstand zur Leiterplatte wirkt die Blendenkante 9 zunehmend feldlinienkonzentrierend auf die Leiterplatte. An dieser Stelle tritt daher eine Schichtdickenüberhöhung 10 auf. Diese Überhöhung setzt sich bis zur seitlichen Leiterplattenkante 5 fort. Der nutzbare Bereich der Leiterplatte ist auch bei diesem Abstand der Blende von der Leiterplatte nicht größer als bei der Anordnung nach Figur 3b.

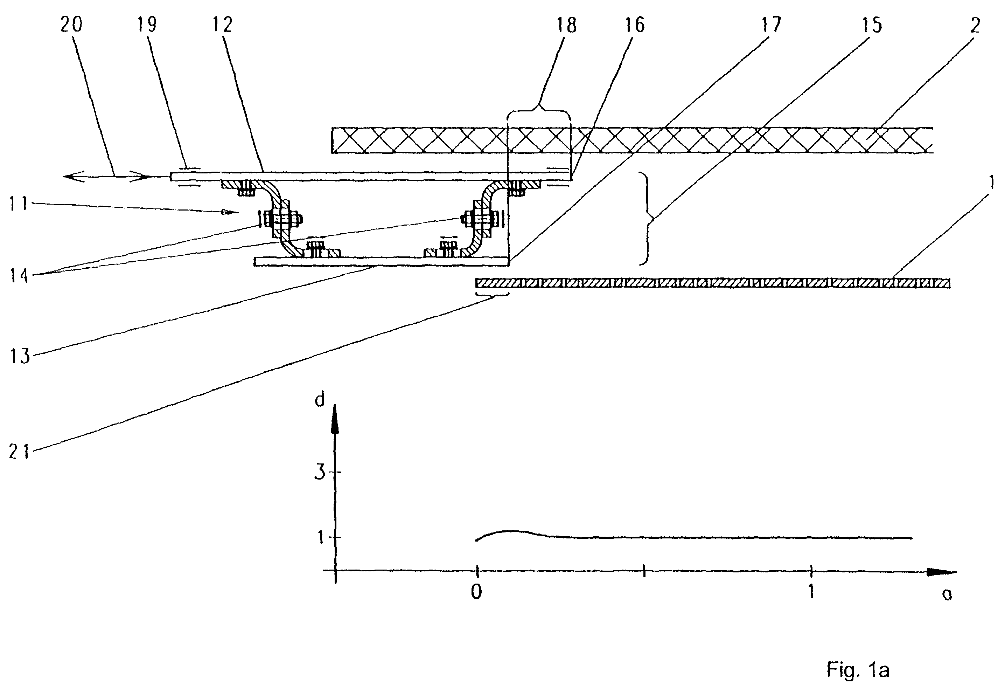

Im Gegensatz dazu ist im oberen Teil der Figur 1a die erfindungsgemäße Doppelblende 11 im Querschnitt gezeigt. Diese besteht aus einem der Gegenelektrode unmittelbar gegenüberliegenden (anodennahen) Flachteil 12 und einem dem Behandlungsgut unmittelbar gegenüberliegenden (kathodennahen) Flachteil 13. Beide Flachteile sind mittels vorzugsweise aus Kunststoff bestehenden Konstruktionselementen 14 miteinander verbunden. Diese Konstruktionselemente erlauben das Verändern der Positionen der Blendenteile 12 und 13 zueinander und in ihrer Lage zur Anode und Kathode. Das bedeutet, daß der Abstand 15 zwischen den beiden Flachteilen sowie die Lage der Vorderkanten 16 und 17 der beiden Blendenteile justierbar sind. Somit ist der Überstand 18 (Abstand b) des Blendenteils 12 über dem Teil 13 einstellbar. Die Doppelblende 11 ist quer zur Transportrichtung verschiebbar in Lagern 19 gelagert.

Selbstverständlich kann auch eine andere konstruktive Lösung zur relativen Einstellung der Blendenteile zueinander gewählt werden.

Die Doppelblende 11 kompensiert bei richtig eingestelllten Blendenparametern den "Schichtdickengraben" 7 und die Schichtdickenüberhöhung 10 (siehe unterer Abbildungsteil in Figur 1a) nahezu vollständig. Justierbare Blendenparameter sind der Abstand 15, der Überstand 18 (Abstand b) und die Lage der Doppelblende im Raum zwischen der Anode und dem Behandlungsgut.

Da der Abstand des anodennahen Blendenteils 12 zur Anode und der Abstand des kathodennahen Blendenteils 13 zum Behandlungsgut nach der Montage der Durchlaufanlage zweckmäßigerweise nicht mehr verändert werden, muß die Justierung des Abstandes 15 und des Überstands 18 (Abstand b) in der Regel nur einmal manuell bei der Inbetriebnahme durchgeführt werden. Ein nicht dargestellter steuerbarer Antrieb bewirkt die Bewegung 20 der Doppelblende 11 und/oder 12 quer zur Transportrichtung.

Wenn nur Leiterplattennutzen mit konstanter Breite bearbeitet werden, brauchen die Blenden nur einmalig von Hand eingestellt zu werden, um eine bestimmte Überdeckung 21 im Randbereich der Leiterplatten zu erhalten.

Bei ständig wechselnden Breiten der Leiterplatten wird die Leiterplattenüberdeckung dagegen vorzugsweise mit einem Motorantrieb mit bekannten Mitteln der Steuerungs- und Antriebstechnik eingestellt.

Die Länge der Blenden quer zur Transportrichtung muß mindestens so groß sein, daß auch bei den schmalsten Leiterplattennutzen eine ausreichende Randabblendung ermöglicht wird.

Grundsätzlich ist es auch möglich, die Blenden 12 und 13 nicht fest miteinander zu verbinden, sondern individuell einzeln quer zur Transportrichtung zu verschieben. Dies ist besonders dann vorteilhaft, wenn in einer Galvanoanlage mit großen Stromdichteunterschieden von einem Behandlungsgut zum anderen produziert wird. Die kathodennahe Blende 13 kann dann zur Vermeidung von Kantenanbrennungen optimal eingestellt werden.

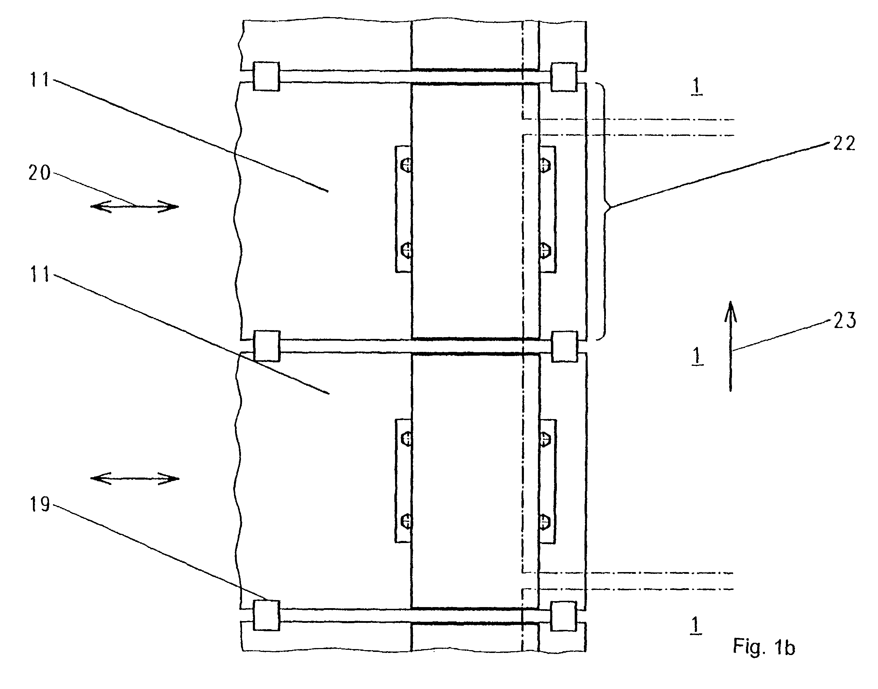

In Figur 1b sind ferner Doppelblenden 11 in Draufsicht mit Blickrichtung zu den Anoden 1 gezeigt. Zwischen den Doppelblenden sind Lager 19 zur Halterung der Blenden angeordnet, die zugleich die Anoden tragen. Die Anoden sollten segmentiert und gegeneinander elektrisch isoliert sein, damit diese beim Einlaufen des Behandlungsgutes in Transportrichtung in die Durchlaufanlage individuell zu- und beim Auslaufen des Behandlungsgutes aus der Anlage abgeschaltet werden können. Diese Funktion ist in der Druckschrift DE-P 39 39 681 A1 beschrieben. Auf diese Druckschrift wird verwiesen. Die erforderliche Breite 22 der Doppelblende richtet sich zweckmäßigerweise nach der Breite eines Anodensegments. Die Transportrichtung des Behandlungsgutes ist durch den Pfeil 23 angezeigt.

In Figur 2 sind Beispiele für bestimmte Ausführungsformen der Flachteile 12 und 13 wiedergegeben. Durch Perforieren der Vorderbereiche der Blendenteile wird der Kanteneffekt etwas verringert. Auch die Ausbildung von Aussparungen an den Vorderkanten 16,17 führt zur Vergleichmäßigung der Metallschicht. Zur Feinjustierung ist eine derartige Perforation und/oder das Anbringen von Aussparungen gut geeignet.

Alle erfindungsgemäßen Maßnahmen bewirken zusammen, daß der nutzbare Bereich eines Leiterplattennutzens auch bei der Feinleitertechnik in der Praxis mindestens bis zu 12 mm an die Leiterplattenkante heranreicht. Eine weitere Feinjustierung kann durch Anordnung eines dritten Blendenteils zwischen den beiden Flachblenden 12 und 13 erreicht werden. Das Anbringen dieses zusätzlichen Blendenteils ist insbesondere vorteilhaft und mit geringem Aufwand verbunden, wenn Leiterplattennutzen mit nur einer einheitlichen Breite in der Durchlaufanlage bearbeitet werden. Ein motorischer Antrieb zur Anpassung der Lage der Blendenteile an wechselnde Formate entfällt in diesem Fall.

### Bezugszeichenliste:

- 1: Behandlungsgut (beispielsweise Leiterplatte)
- 2: Gegenelektrode (beispielsweise Anode)
- 3: Kontaktierbereich
- 4: Schichtdickenverlauf
- 5: Leiterplattenkante
- 6: überstehender Gegenelektrodenbereich
- 7: "Schichtdickengraben"
- 8: Einfachblende nach dem Stand der Technik
- 9: Vorderkante der Einfachblende 8
- 10: Schichtdickenüberhöhung
- 11: Doppelblende
- 12: der Gegenelektrode unmittelbar gegenüberliegendes (anodennahes) Blendenteil
- 13: dem Behandlungsgut unmittelbar gegenüberliegendes (kathodennahes) Blendenteil
- 14: Konstruktionselemente zur Justierung der Blendenteile 12 und 13
- 15: Abstand der Blendenteile 12 und 13 voneinander
- 16: Vorderkante des Blendenteils 12
- 17: Vorderkante des Blendenteils 13
- 18: Überstand der der Gegenelektrode gegenüberliegenden Blende 12 über die dem Behandlungsgut gegenüberliegende Blende 13 (Abstand b)
- 19: Lager zur Halterung der Doppelblende
- 20: Blendenbewegung
- 21: Leiterplattenüberdeckung
- 22: Blendenbreite
- 23: Transportrichtung

## Patentansprüche

1. Vorrichtung zum elektrolytischen Behandeln von plattenförmigem Behandlungsgut in einer Durchlaufanlage, durch die das Behandlungsgut in einer Transportebene in im wesentlichen horizontaler Transportrichtung hindurchführbar ist, wobei die Vorrichtung
a. der Transportebene im wesentlichen parallel gegenüberliegende Gegenelektroden (2) sowie
b. zwischen der Transportebene und den Gegenelektroden angeordnete Blenden (11) zum Abschirmen erhöhter Stromdichtefelder im Randbereich des Behandlungsgutes (1) aufweist,
c. wobei die Blenden jeweils in Form von mindestens zwei im wesentlichen parallel zueinander angeordneten Flachteilen (12,13) ausgebildet sind und der eine Teil (13) der Blenden der Transportebene und der andere Teil (12) den Gegenelektroden gegenüberliegend angeordnet ist und
d. wobei die Blenden in einer Richtung (20) verschiebbar gelagert sind, die im wesentlichen parallel zur Transportebene und im wesentlichen senkrecht zur Transportrichtung (23) verläuft.

2. Vorrichtung nach Anspruch 1, **dadurch gekennzeichnet, daß** der der Transportebene unmittelbar gegenüberliegende Teil (13) der Blenden (11) gegenüber dem anderen Teil (12) um einen Abstand b zur Kante des Behandlungsgutes (1) hin zurückspringend angeordnet ist.

3. Vorrichtung nach einem der vorstehenden Ansprüche, **dadurch gekennzeichnet, daß** die Flachteile (12,13) unabhängig voneinander verschiebbar gelagert sind.

4. Vorrichtung nach einem der vorstehenden Ansprüche, **dadurch gekennzeichnet, daß** der Abstand b durch geeignete Konstruktionselemente (14) einstellbar ist.

5. Vorrichtung nach einem der vorstehenden Ansprüche, **dadurch gekennzeichnet, daß** die Abstände der Flachteile (12,13) zur Gegenelektrode (2) und zur Transportebene unabhängig voneinander einstellbar sind.

6. Vorrichtung nach einem der vorstehenden Ansprüche, **dadurch gekennzeichnet, daß** ein steuerbarer Motorantrieb vorgesehen ist, mit dem die Blenden (11) verschiebbar sind.

7. Vorrichtung nach einem der vorstehenden Ansprüche, **dadurch gekennzeichnet, daß** die Flachteile (12,13) Randbereiche aufweisen, die mit dem Behandlungsgut (1) und den Gegenelektroden (2) zur Überdeckung bringbar sind, wobei diese Randbereiche Durchbrechungen und/oder an den Kanten Aussparungen aufweisen.

8. Vorrichtung nach einem der vorstehenden Ansprüche, **dadurch gekennzeichnet, daß** die Flachteile (12,13) senkrecht zur Transportrichtung (23) gesehen so breit sind, daß schmales Behandlungsgut (1) im Randbereich sicher abgeblendet werden kann.

9. Vorrichtung nach einem der vorstehenden Ansprüche, **dadurch gekennzeichnet, daß** die Gegenelektroden (2) in Transportrichtung (23) gesehen in mehrere Teilsegmente unterteilt sind und die Blenden (11) eine Länge in Transportrichtung aufweisen, die der Länge der Teilsegmente der Gegenelektroden (11) entspricht.

10. Verfahren zum elektrischen Abschirmen von Randbereichen von plattenförmigem Behandlungsgut bei dessen elektrolytischer Behandlung in einer Durchlaufanlage, durch die das Behandlungsgut in einer Transportebene in im wesentlichen horizontaler Transportrichtung hindurchgeführt wird,
a. wobei zwischen der Transportebene und Gegenelektroden (2), die der Transportebene im wesentlichen parallel gegenüberliegen, Blenden (11) zum Abschirmen erhöhter Stromdichtefelder im Randbereich des Behandlungsgutes (1) angeordnet werden,
b. wobei ferner die Blenden jeweils in Form von mindestens zwei im wesentlichen parallel zueinander angeordneten Flachteilen (12,13) ausgebildet werden und der eine Teil (13) der Blenden der Transportebene und der andere Teil (12) den Gegenelektroden gegenüberliegend angeordnet wird und
c. wobei die Blenden in einer Richtung (20) verschiebbar gelagert sind, die im wesentlichen parallel zur Transportebene und senkrecht zur Transportrichtung (23) verläuft.

## Claims

1. Apparatus for electrolytically treating plate-like material to be treated in a continuous system, the material to be treated being guidable through said system in a plane of conveyance in a substantially horizontal direction of conveyance, wherein the apparatus includes
a. counter-electrodes (2), which lie substantially parallel to and opposite the plane of conveyance, as well as
b. screens (11), which are disposed between the plane of conveyance and the counter-electrodes, for shielding high current density fields in the edge region of the material to be treated (1),
c. each of the screens being in the form of at least two flat members (12,13), which are disposed substantially parallel to each other, and one member (13) of the screens being disposed opposite the plane of conveyance, and the other member (12) being disposed opposite the counter-electrodes, and
d. the screens being mounted so as to be displaceable in a direction (20) which runs substantially parallel to the plane of conveyance and substantially perpendicularly relative to the direction of conveyance (23).

2. Apparatus according to claim 1, **characterised in that** the member (13) of the screens (11), which lies directly opposite the plane of conveyance, is disposed opposite the other member (12) so as to spring-back by a spacing b towards the edge of the material to be treated (1).

3. Apparatus according to one of the preceding claims, **characterised in that** the flat members (12,13) are mounted so as to be displaceable independently of each other.

4. Apparatus according to one of the preceding claims, **characterised in that** the spacing b is adjustable by means of suitable structural elements (14).

5. Apparatus according to one of the preceding claims, **characterised in that** the spacings between the flat members (12,13) and the counter-electrode (2) and the plane of conveyance are adjustable independently of one another.

6. Apparatus according to one of the preceding claims, **characterised in that** a controllable motor drive is provided, by means of which the screens (11) are displaceable.

7. Apparatus according to one of the preceding claims, **characterised in that** the flat members (12,13) have edge regions which can be brought to coincide with the material to be treated (1) and the counter-electrodes (2), these edge regions having openings and/or recesses at the edges.

8. Apparatus according to one of the preceding claims, **characterised in that** the flat members (12,13) are so wide, when viewed perpendicularly relative to the direction of conveyance (23), that narrow material to be treated (1) can be reliably screened in the edge region.

9. Apparatus according to one of the preceding claims, **characterised in that**, when viewed with respect to the direction of conveyance (23), the counter-electrodes (2) are divided into a plurality of partial segments and, when viewed with respect to the direction of conveyance, the screens (11) have a length which corresponds to the length of the partial segments of the counter-electrodes (11).

10. Method of electrically shielding edge regions of plate-like material to be treated during the electrolytic treatment thereof in a continuous system, through which the material to be treated is conducted in a plane of conveyance in a substantially horizontal direction of conveyance,
a. wherein screens (11) are disposed between the plane of conveyance and counter-electrodes (2), which lie opposite and substantially parallel to the plane of conveyance, for shielding high current density fields in the edge region of the material to be treated (1),
b wherein also the screens are each in the form of at least two flat members (12,13), which are disposed substantially parallel to each other, and one member (13) of the screens is disposed so as to lie opposite the plane of conveyance, and the other member (12) is disposed so as to lie opposite the counter-electrodes, and
c. wherein the screens are mounted so as to be displaceable in a direction (20) which runs substantially parallel to the plane of conveyance and perpendicularly relative to the direction of conveyance (23).

## Revendications

1. Dispositif pour le traitement électrolytique d'articles à traiter sous forme de plaquettes dans une installation en continu, à travers laquelle on peut faire passer les articles à traiter sur un plan de transport dans une direction de transport essentiellement horizontale, le dispositif présentant
a) des contre-électrodes (2) opposées au plan de transport de façon essentiellement parallèle, ainsi que
b) des écrans (11) agencés entre le plan de transport et les contre-électrodes pour protéger des champs de densité de courant accrue dans la zone périphérique des articles à traiter (1),
c) dans lequel les écrans sont réalisés respectivement sous la forme d'au moins deux pièces planes (12, 13) agencées essentiellement en parallèle l'une à l'autre et l'une (13) des parties d'écran est agencée à l'opposé du plan de transport et l'autre partie (12) est agencée à l'opposé des contre-électrodes, et
d) dans lequel les écrans sont logés de façon mobile dans une direction (20) qui s'étend pour l'essentiel en parallèle au plan de transport et pour l'essentiel perpendiculairement à la direction de transport (23).

2. Dispositif selon la revendication 1, **caractérisé en ce que** ladite partie (13) des écrans (11) immédiatement opposée au plan de transport est agencée à l'opposé de l'autre partie (12) en retrait d'une distance b par rapport au bord des articles à traiter (1).

3. Dispositif selon l'une quelconque des revendications précédentes, **caractérisé en ce que** les pièces planes (12, 13) sont logées de façon mobile indépendamment l'une de l'autre.

4. Dispositif selon l'une quelconque des revendications précédentes, **caractérisé en ce que** la distance b est réglable par des éléments de construction (14) adéquats.

5. Dispositif selon l'une quelconque des revendications précédentes, **caractérisé en ce que** les distances des pièces planes (12, 13) par rapport à la contre-électrode (2) et au plan de transport sont réglables indépendamment l'une de l'autre.

6. Dispositif selon l'une quelconque des revendications précédentes, **caractérisé en ce qu'**une commande par moteur dirigible est prévue qui permet de déplacer les écrans (11).

7. Dispositif selon l'une quelconque des revendications précédentes, **caractérisé en ce que** les pièces planes (12, 13) présentent des zones périphériques qui peuvent être amenées en recouvrement avec les articles à traiter (1) et les contre-électrodes (2), dans lequel ces zones périphériques présentent des passages et/ou des évidements aux bords.

8. Dispositif selon l'une quelconque des revendications précédentes, **caractérisé en ce que** les pièces planes (12, 13), vues perpendiculairement à la direction de transport (23), ont une largeur telle que des articles à traiter étroits (1) peuvent être protégés sûrement dans la zone périphérique.

9. Dispositif selon l'une quelconque des revendications précédentes, **caractérisé en ce que** les contre-électrodes (2), vues dans la direction de transport (23), sont divisées en plusieurs segments partiels et les écrans (11) présentent une longueur dans la direction de transport qui correspond à la longueur des segments partiels des contre-électrodes (11).

10. Procédé pour protéger électriquement des zones périphériques d'articles à traiter sous forme de plaquettes, au cours du traitement électrolytique duquel, dans une installation en continu à travers laquelle on fait passer les articles à traiter sur un plan de transport dans une direction de transport essentiellement horizontale,
a) dans lequel entre le plan de transport et les contre-électrodes (2), qui sont opposées au plan de transport essentiellement en parallèle, des écrans (11) pour la protection de champs de densité de courant accrue sont agencés dans la zone périphérique des articles à traiter (1),
b) dans lequel en outre, les écrans sont réalisés respectivement sous la forme d'au moins deux pièces planes (12, 13) agencées essentiellement en parallèle l'une à l'autre et une partie (13) des écrans est agencée à l'opposé du plan de transport et l'autre partie (12) est agencée à l'opposé des contre-électrodes, et
c) dans lequel les écrans sont logés de façon mobile dans une direction (20) qui s'étend pour l'essentiel en parallèle au plan de transport et perpendiculairement à la direction de transport (23).
